**Europäisches Patentamt**

**European Patent Office**

**Office européen des brevets**

(19)

(11) Veröffentlichungsnummer : **0 136 591**
**B1**

(12)    **EUROPÄISCHE PATENTSCHRIFT**

(45) Veröffentlichungstag der Patentschrift :
**02.03.88**

(21) Anmeldenummer : **84110628.9**

(22) Anmeldetag : **06.09.84**

(51) Int. Cl.⁴ : **G 01 R 31/28**

(54) **Verfahren zum Messen niederfrequenter Signalverläufe innerhalb integrierter Schaltungen mit der Elektronensonde.**

(30) Priorität : **23.09.83 DE 3334494**

(43) Veröffentlichungstag der Anmeldung :
**10.04.85 Patentblatt 85/15**

(45) Bekanntmachung des Hinweises auf die Patenterteilung : **02.03.88 Patentblatt 88/09**

(84) Benannte Vertragsstaaten :
**AT BE CH DE FR GB IT LI LU NL SE**

(56) Entgegenhaltungen :
**EP-A- 0 062 097**
**EP-A- 0 075 710**

(73) Patentinhaber : **Siemens Aktiengesellschaft Berlin und München**
**Wittelsbacherplatz 2**
**D-8000 München 2 (DE)**

(72) Erfinder : **Fazekas, Peter, Dipl.-Ing.**
**Stuntzstrasse 21**
**D-8000 München 80 (DE)**

Jouve, 18, rue St-Denis, 75001 Paris, France

## Beschreibung

Die Erfindung betrifft ein Verfahren zur Messung eines niederfrequenten Signalverlaufes innerhalb einer integrierten Schaltung mit einer Elektronensonde nach dem Oberbegriff des Anspruchs 1. Ein solches Verfahren ist aus dem Dokument EP-A-0 075 710 bekannt.

Echtzeitmessungen niederfrequenter Signalverläufe im Innern integrierter Schaltungen wurden bisher mit einem Echtzeitmeßverfahren mit einer nicht-gepulsten Elektronensonde durchgeführt (H. P. Feuerbaum et al, Beiträge zur elektronenmikroskopischen Direktabbildung von Oberflächen 1975, Bd. 8, Seiten 469-480). Die gewonnenen Meßkurven wurden dabei an einem Oszillografen dargestellt. Der Nachteil dieses bekannten Verfahrens ist eine übermäßige Belastung der integrierten Schaltungen während der Meßstellensuche, die zu starken Aufladungen der zu untersuchenden Schaltung führt, welche ihrerseits wiederum die Güte der Meßergebnisse beeinträchtigen.

Der vorliegenden Erfindung liegt die Aufgabe zugrunde, ein Verfahren der eingangs genannten Art anzugeben, bei dem die Belastung der Schaltung möglichst gering gehalten werden kann.

Diese Aufgabe wird erfindungsgemäß durch ein Verfahren nach dem Anspruch 1 gelöst.

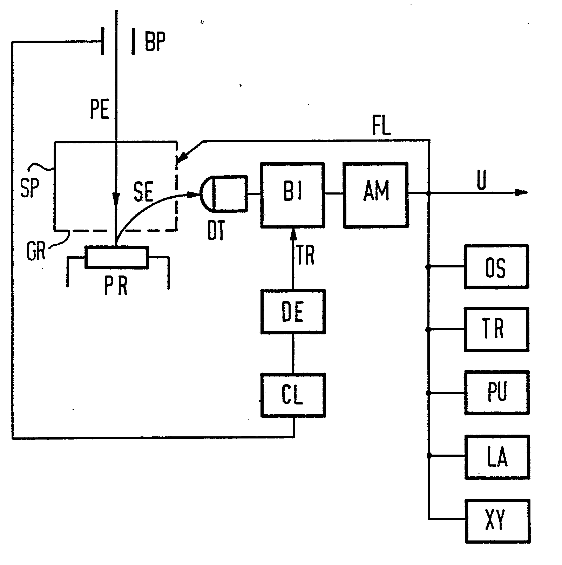

Ausgestaltungen und Vorteile der Erfindung sind in den abhängigen Ansprüchen, der Beschreibung und der Zeichnung dargestellt.

Die Erfindung ist anhand der Zeichnung näher erläutert.

Die Figur zeigt ein Beispiel für eine Vorrichtung zur Durchführung eines erfindungsgemäßen Verfahrens.

Um die Belastung der Schaltung PR möglichst gering zu halten, wird während der Meßstellensuche und während der Messung eine gepulste Elektronensonde PE verwendet. Die Eintastfrequenz der Elektronensonde PE ist unabhängig von der Betriebsfrequenz der Schaltung PR. Bei Verwendung einer Torschaltung BI, beispielsweise eines boxcar-Integrators, in der Signalverarbeitungskette des Elektronenstrahl-Meßgerätes kann ein großes Tastverhältnis für die Impulsfolge der Elektronenstrahlpulse PE gewählt werden. Das Tastverhältnis ist als Kenngröße einer Impulsfolge aus rechteckförmigen Einzelimpulsen, d. h. einer sich periodisch wiederholenden Folge einzelner rechteckförmiger Impulse, als Verhältnis von Periodendauer zu Impulsdauer definiert.

Wenn ein Signalverlauf an einem Meßpunkt der Probe PR gemessen wird, treffen die Primärelektronen PE, die ein bestimmtes Tastverhältnis aufweisen, auf den Meßpunkt der Probe PR auf und lösen dort bei einer bestimmten Phase des niederfrequenten Signalverlaufes Sekundärelektronen SE aus. Eine Änderung des Potentials an dem Meßpunkt entsprechend dem niederfrequenten Signalverlauf verursacht eine Verschiebung der Energieverteilung der Sekundärelektronen SE. Diese Energieverschiebung der Sekundärelektronen SE wird üblicherweise mit Hilfe eines Gegenfeldspektrometers SP nachgewiesen. Der Strom der Sekundärelektronen SE, der zum Detektor DT gelangt, ist eine Funktion des Gegenfeldes an der retardierenden Elektrode GR des Gegenfeldspektrometers SP.

Das von den Sekundärelektronen SE im Detektor DT ausgelöste Meßsignal gelangt zur Torschaltung BI, beispielsweise zum Eingangstor eines boxcar-Integrators. Dabei kann ein boxcar-Integrator PAR Modell 162 der Fa. Princeton Applied Research verwendet werden. Ein boxcar-Integrator weist im wesentlichen eine integrierende Torschaltung, beispielsweise eine sample-and-hold-Schaltung auf, welche periodische, mit Rauschen behaftete Signale dadurch messen kann, daß sie mehrmals hintereinander einen Signalverlauf bei einer bestimmten Phase dieses Signalverlaufes abtastet und durch Mittelung über die entsprechenden Meßsignale, die zur selben Phase des Signalverlaufes gehören, das Signal-Rausch-Verhältnis beim Ausgangssignal U eines Elektronenstrahl-Meßgerätes wesentlich verbessert.

Das Ausgangssignal der Torschaltung BI wird in einem Regelverstärker AM verstärkt und liefert dort das Ausgangssignal U des Elektronenstrahl-Meßgerätes. Die Signalverarbeitungskette, bestehend aus DT, Torschaltung BI und Regelverstärker AM, wird zu einem Regelkreis FL geschlossen, der die Spannung an der retardierenden Elektrode GR des Gegenfeldspektrometers SP steuert. Wie ein solcher Regelkreis FL bei einem Elektronenstrahl-Meßgerät üblicherweise funktioniert, ist in den Patentschriften US-A-4 220 854 und US-A-4 277 679 beschrieben.

Die Taktschaltung CL steuert eine Einrichtung BP zur Strahlaustastung der Primärelektronen PE und triggert über eine Verzögerungsschaltung DE den Triggereingang TR der Torschaltung BI. Die Verzögerungsschaltung DE ist notwendig, um die Laufzeiten der Primärelektronen von der Einrichtung BP zur Strahlaustastung zum Meßpunkt auf der Probe PR und die Laufzeit der Sekundärelektronen vom Meßpunkt auf der Probe PR zum Detektor DT zu kompensieren, so daß das Tor der Torschaltung BI genau dann geöffnet ist, wenn das Sekundärelektronen-Meßsignal am Eingang dieser Torschaltung BI anliegt. Die Verzögerungsschaltung DE muß eine Verzögerung von etwa 200 ns bewirken. Eine solche Verzögerungsschaltung kann ein Fachmann ohne weiteres käuflich erwerben.

Bei Verwendung einer Torschaltung BI ist der Inhalt des Meßsignals U unabhängig vom Tastverhältnis der Primärelektronenpulse PE. Daher kann bei Verwendung einer Torschaltung BI ein großes Tastverhältnis bei den Primärelektronenpulsen PE verwendet werden, ohne daß die Gefahr besteht, daß ein im Detektor DT verwendeter Fotomultiplier in den Sättigungsbereich gerät. Die Torschaltung BI ermöglicht weiter, daß das Meßsignal U unempfindlich gegenüber Leckströmen ist, vor allem dann, wenn das Tastverhältnis der Primärelektronenpulse PE groß ist.

Bei der Echtzeitmessung niederfrequenter Signalverläufe an einem Meßpunkt einer Probe PR wird die Elektronensonde PE mit einer von der Betriebsfrequenz der Schaltung unabhängigen Frequenz, die von der Taktschaltung CL vorgegeben wird, eingetastet. Synchron mit der Frequenz der Primärelektronenpulse PE wird das Tor der Torschaltung BI getriggert. Bei der Echtzeitmessung eines niederfrequenten Signalverlaufes, bei welcher der zu messende niederfrequente Signalverlauf nicht wiederholt wird, weist die Primärelektronensonde beispielsweise eine Pulsfrequenz im MHz-Bereich auf, während der niederfrequente Signalverlauf eine Frequenz von weniger als 100 kHz aufweist. Die Frequenz der Primärelektronenpulse PE ist also um mindestens eine Größenordnung höher als die Frequenz des niederfrequenten Signalverlaufes.

Beträgt beispielsweise die Frequenz des niederfrequenten Signalverlaufes 1 Hz und beträgt die Pulsfrequenz der Primärelektronensonde PE etwa 10 MHz, so treffen beispielsweise während einer Periode des niederfrequenten Signalverlaufes $10^7$ Primärelektronenpulse hintereinander auf den Meßpunkt auf. Da die Frequenz des niederfrequenten Signalverlaufes und die Pulsfrequenz der Primärelektronensonde PE von verschiedener Größenordnung sind, ist eine Phasenverschiebung der Primärelektronenpulse PE bezüglich des niederfrequenten Signalverlaufes bei der Echtzeitmessung dieses niederfrequenten Signalverlaufes nicht notwendig ; dies bedeutet, daß beispielsweise ein boxcar-Integrator, der als Torschaltung BI verwendet wird, bei einer solchen erfindungsgemäßen Verwendung als ein Verstärker mit sample-and-hold-Eingang arbeitet. Eine Phasenverschiebung der Primärelektronenpulse bezüglich eines Signalverlaufes an einem Meßpunkt erfolgt beispielsweise bei einem höherfrequenten Signalverlauf an diesem Meßpunkt bei einem sogenannten Sampling-Verfahren nach dem Stand der Technik, wie es beispielsweise in der US-Patentschrift 4 220 854 beschrieben ist.

Der niederfrequente Signalverlauf U wird als Funktion der Zeit t am Oszillografen eines Rasterelektronenmikroskopes dargestellt. Die Aufzeichnung des Meßergebnisses kann im oberen Frequenzbereich der Echtzeitmessung bei Frequenzen größer als 1 Hz mit einem Speicheroszillografen OS, einem Transientenrecorder TR oder einem Rechner PU erfolgen. Bei Frequenzen unter 1 Hz des niederfrequenten Signalverlaufes kann neben den genannten Geräten auch noch ein X-Y-Schreiber X, Y verwendet werden. Für die Logikanalyse des niederfrequenten Signalverlaufes kann ein Logikanalysator LA das Meßsignal U direkt übernehmen.

**Patentansprüche**

1. Verfahren zur Messung niederfrequenter Signalverläufe an einem Meßpunkt einer Probe (PR) bei dem eine gepulste Elektronensonde (PE) auf dem Meßpunkt positioniert wird, bei dem die vom Potential des Meßpunktes abhängige Verschiebung der Energieverteilung der auf der Probe (PR) ausgelösten Sekundärelektronen (SE) in einer Spektrometer-Detektoranordnung (SP, DT) bestimmt wird und bei dem das von den Sekundärelektronen (SE) im Detektor (DT) ausgelöste Signal in einer dem Detektor (DT) nachgeschalteten Signalkette weiterverarbeitet und aufgezeichnet wird, dadurch gekennzeichnet, daß die Pulsfrequenz der Elektronensonde (PE) unabhängig von der Betriebsfrequenz der Probe (PR) gewählt wird und daß eine über eine Verzögerungsschaltung (DE) synchron mit der Elektronensonde (PE) angesteuerte Torschaltung (BI) zur Signalverarbeitung verwendet wird.

2. Verfahren nach Anspruch 1, dadurch gekennzeichnet, daß das Ausgangssignal der Signalkette (BI, AM, FL) mit einem Speicheroszillographen (OS) aufgezeichnet wird.

3. Verfahren nach Anspruch 1, dadurch gekennzeichnet, daß das Ausgangssignal der Signalkette (BI, AM, FL) mit einem Transientenrecorder (TR) aufgezeichnet wird.

4. Verfahren nach Anspruch 1, dadurch gekennzeichnet, daß das Ausgangssignal (U) der Signalkette (BI, AM, FL) mit einem Rechner (PU) aufgezeichnet wird.

5. Verfahren nach Anspruch 1, dadurch gekennzeichnet, daß das Ausgangssignal (U) der Signalkette (BI, AM, FL) mit einem Logikanalysator (LA) aufgezeichnet wird.

6. Verfahren nach Anspruch 1, dadurch gekennzeichnet, daß das Ausgangssignal (U) der Signalkette (BI, AM, FL) mit einem X-Y-Schreiber (X, Y) aufgezeichnet wird.

**Claims**

1. A method of measuring low-frequency signal curves at a measurement point of a sample (PR) in which a pulsed electron probe (PE) is positioned at the measurement point, where each shift in the energy distribution of the secondary electrons (SE) triggered on the sample (PR), which shift is dependent upon the potential of the measurement point, is determined in a spectrometer detector arrangement (SP, DT), and where the signal triggered by the secondary electrons (SE) in the detector (DT) is further processed and recorded in a signal chain which is connected to the output of the detector (DT), characterised in that the pulse frequency of the electron probe (PE) is selected independently of the operating frequency of the sample (PR), and that a gate circuit (BI) which is driven via a delay circuit (DE) in synchronism with the electron probe (PE), is used for the signal processing.

2. A method as claimed in claim 1, characterised in that the output signal of the signal chain (BI, AM, FL) is recorded by a store oscillograph (OS).

3. A method as claimed in claim 1, characterised in that the output signal of the signal chain (BI, AM, FL) is recorded by means of a transient recorder (TR).

4. A method as claimed in claim 1, characterised in that the output signal (U) of the signal chain (BI, AM, FL) is recorded by means of a computer (PU).

5. A method as claimed in claim 1, characterised in that the output signal (U) of the signal chain (BI, AM, FL) is recorded by means of a logic analyser (LA).

6. A method as claimed in claim 1, characterised in that the output signal (U) of the signal chain (BI, AM, FL) is recorded by means of an X-Y-recorder (X, Y).

**Revendications**

1. Procédé pour mesurer des allures de signaux basse fréquence sur un point de mesure d'un circuit à contrôler (PR), selon lequel on place une sonde à électrons (PE) pulsée sur le point de mesure, selon lequel le décalage de la distribution de l'énergie des électrons secondaires (SE) dont l'émission a été provoquée sur le circuit à contrôler (PR), décalage qui dépend du potentiel du point de mesure, est déterminé dans un système spectromètre-détecteur (SP, DT), et selon lequel le signal déclenché par les électrons secondaires (SE) dans le détecteur (DT) est soumis à un traitement consécutif dans une chaîne de traitement de signal montée à la suite du détecteur (DT) et est enregistré, caractérisé en ce que l'on choisit la fréquence de succession des impulsions de la sonde à électrons (PE) indépendante de la fréquence de fonctionnement du circuit à contrôler (PR) et on utilise, pour le traitement du signal, un circuit porte (BI) qui est attaqué en synchronisme avec la sonde à électrons (PE) à travers un circuit à retard (DE).

2. Procédé selon la revendication 1, caractérisé en ce que l'on enregistre le signal de sortie de la chaîne de traitement du signal (BI, AM, FL) à l'aide d'un oscilloscope à mémoire (OS).

3. Procédé selon la revendication 1, caractérisé en ce que l'on enregistre le signal de sortie de la chaîne de traitement du signal (BI, AM, FL) à l'aide d'un enregistreur de réponses indicielles (TR).

4. Procédé selon la revendication 1, caractérisé en ce que l'on enregistre le signal de sortie (U) de la chaîne de traitement du signal (BI, AM, FL) à l'aide d'un calculateur (PU).

5. Procédé selon la revendication 1, caractérisé en ce que l'on enregistre le signal de sortie (U) de la chaîne de traitement du signal (BI, AM, FL) à l'aide d'un analyseur logique (LA).

6. Procédé selon la revendication 1, caractérisé en ce que l'on enregistre le signal de sortie (U) de la chaîne de traitement du signal (BI, AM, FL) à l'aide d'un enregistreur à coordonnées X-Y (X, Y).